# EUROPEAN PATENT SPECIFICATION

(11) **EP 0 706 224 B1**
(45) Date of publication and mention of the grant of the patent: **28.04.1999**
(21) Application number: 95118099.1
(22) Date of filing: 05.10.1993
(51) Int. Cl.: H01L 29/788

(54) **Method of erasing data from semiconductor nonvolatile memory**
Methode zum Löschen von Daten in einem nichtflüchtigen Halbleiterspeicher
Méthode pour effacer des données d'une mémoire semi-conductrice non-volatile

(30) Priority: 09.10.1992 JP 271379/92
(43) Date of publication of application: 10.04.1996
(62) Divisional of application: 93307897.4
(73) Proprietor: Oki Electric Industry Co., Ltd., Tokyo (JP)
(72) Inventor: Ono, Takashi, c/o Electric Industry Co. Ltd., Tokyo (JP)
(74) Representative: Boydell, John Christopher

(56) References cited:
- US-A- 4 907 197
- ELECTRONIC DESIGN, vol.31, no.17, August 1983, HASBROUCK HEIGHTS, NJ, USA pages 189 - 196 F. JONES ET AL.
- IEEE TRANSACTIONS ON ELECTRON DEVICES, vol.36, no.9-I, September 1989 pages 1663 - 1682, XP87131 J.S. WITTERS ET AL.
- IEEE JOURNAL OF SOLID-STATE CIRCUITS, vol.SC-15, no.3, June 1980 pages 353 - 357 A. SCHEIBE ET AL.

## Description

This invention relates to a semiconductor nonvolatile memory, and particularly to a method of erasing data from an electrically data-reloadable semiconductor nonvolatile memory. This patent application is a divisional of our copending European application No. 93307897.4

As electrically data-reloadable ROMs (Read Only Memory), there has heretofore been proposed various flash EEPROMS (Electrical Erasable and Programmable ROM) memory cells.

For example, a sidewall type flash EEPROM cell has been described in "IEDM 1989 P. 603 TO 606 'A New Flash-Erase EEPROM CELL With a Sidewall Select-Gate on its Source Side' K. Naruke et al."

In this type of sidewall type flash EEPROM cell, the writing of data therein is effected by injecting hot electrons thereof into a floating gate.

In this case, an energy of 3.1eV or higher is required to write the data in the sidewall type flash EEPROM cell in view of the structure of the sidewall type flash EEPROM cell to be described later.

Further, when the data is written into the cell under such high energy, the number of times in which the data is rewritten or reloaded reaches several thousands or so.

The article "EEPROM adapts easily to in-system changes" by F. Jones et al, published in Electronics Design, vol. 31 (1983) Aug. No. 17, pages 189-196, describes a method of programming a Flash EEPROM. The flash EEPROM described comprises first and second diffusion regions formed on a p-well, which diffusion regions are termed the drain and the source respectively. Formed over the p-well, in between the drain and the source, is a silicon nitride layer with an ultra-thin tunnelling layer of silicon dioxide between the substrate and the nitride layer. The nitride layer, which acts as a floating gate, is formed between and partly overlapping an isolation gate and a selection gate. Furthermore a storage gate is formed above the nitride layer. A first channel region exists in the upper surface of the p-well substrate beneath the nitride adjacent the p-well substrate, a second channel region exists beneath the isolation gate and a third channel region exists beneath the select gate; each of these channel regions may be inverted by the application of a sufficiently large voltage to the respective gate immediately above the channel region, or, in the case of the first channel region by the application of a suitable voltage to the storage gate. The method of programming described involves applying a high voltage (about 20V) to the storage gate, a similarly high voltage to the selection gate and a low voltage (about 0V) to the drain. The application of these voltages inverts the first and third channel regions and allows charge to be transferred to the nitride layer by electron tunnelling from the first channel region to the nitride layer via the ultra-thin silicon oxide tunnelling layer.

The article "A two-transistor SIMOS EAROM cell" by A. Scheibe and W. Krauss published in IEEE Journal of solid-state circuits Vol. Sc-15 (1980) June, No. 3, pages 353-357 describes a new electrically-alterable nonvolatile memory cell consisting of a floating gate memory transistor and an access transistor. Programming of the cell is achieved by two mechanisms: channel injection of hot electrons and field emission. Erasure is achieved by Fowler-Nordheim electron injection from the floating gate through a thin oxide thermally grown on monosilicon to an n⁺ diffusion region placed outside the channel region of the memory transistor.

According to the present invention there is provided a method of erasing data from a semiconductor nonvolatile memory device having a drain and a source diffusion region of a first conductivity type in a semiconductor well region of a second conductivity type, a control gate over a floating gate disposed over the whole of a first channel region, and a select gate disposed over a second channel region, the first channel region adjoining the drain diffusion region and extending therefrom, the second channel region extending between the source diffusion region and the first channel region and adjoining these regions, said method comprising the steps of: applying a first voltage (V_{CG}) to the control gate; and simultaneously applying to the semiconductor well region a second voltage (V_{W}) which is higher than the first voltage so that an electric charge stored in the floating gate is transferred to the semiconductor well region by a Nordheim-Fowler tunnelling current into the semiconductor well region.

In order that the invention may be better understood, an embodiment thereof will now be described, by way of example only, with reference to the accompanying drawings in which:-
Figure 1 is a cross-sectional view showing a sidewall type flash EEPROM cell;
Figure 2 is a view for describing a first method of writing data into a sidewall type flash EEPROM cell;
Figure 3 is a circuit diagram showing a memory device in which a plurality of N type and sidewall type flash EEPROM cells have been arranged;
Figure 4 is a view for describing a second method of writing data into a sidewall type flash EEPROM cell;
Figure 5 is a view for describing a method of erasing data from a sidewall type flash EEPROM cell, according to an embodiment of the present invention; and
Figure 6 is a graph for describing the relationship between the number of times in which data is repeatedly written and erased and a threshold voltage (V_{T}) at the time that data is written under the action of conventional hot electrons and data is written into the sidewall type flash EEPROM cell described in relation to the above first method.

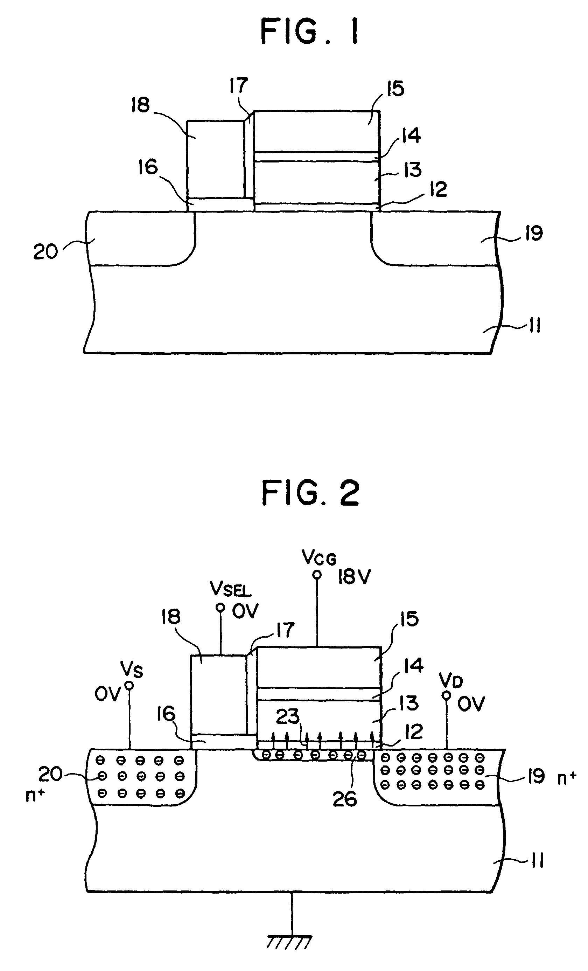

Figure 1 is a cross-sectional view showing a sidewall type flash EEPROM cell. Figure 2 is a view for explaining a first method of writing data into a sidewall type flash EEPROM cell.

The configuration of the sidewall type flash EEPROM cell shown in Figure 1 will first be described. A gate insulative film 12 having a film thickness ranging from 50 Å to 150Å is formed on a mono-crystalline silicon substrate 11. A floating gate 13 composed of polycrystalline silicon is deposited on the gate insulative film 12. Further, an insulative film 14 is formed on the floating gate 13 and a control gate 15 composed of the polycrystalline silicon is fabricated on the insulative film 14.

An insulative film 16 is formed on the monocrystalline silicon substrate 11. A sidewall type select gate 18 made up of the polycrystalline silicon is formed on the insulative film 16. The sidewall type select gate 18 is insulated from the floating gate 13 and the control gate 15 by an insulative film 17.

Next, a drain diffusion layer 19 and a source diffusion layer 20 are formed on the surface of the monocrystalline silicon substrate 11.

The drain diffusion layer 19 is formed on the floating gate 13 side, whereas the source diffusion layer 20 is formed on the select gate 18 side.

A first data writing method will now be described with reference to Figure 2. Figure 2 is a cross-sectional view of an N type and sidewall type flash EEPROM cell. N-type impurities are implanted into the drain diffusion layer 19 and the source diffusion layer 20. The same elements of structure as those shown in Figure 1 are identified by the same reference numerals.

A drain voltage V_{D} applied to the drain diffusion layer 19, a control gate voltage V_{CG} applied to the control gate 15, a select gate voltage V_{SEL} applied to the select gate 16, a source voltage V_{S} applied to the source diffusion layer 20 and a substrate voltage applied to the silicon substrate 11 will be set as OV, 18V, OV, OV and OV respectively. However, the source voltage is not necessarily limited to OV. The source voltage may be about 10V or below or may be a floating state.

An inversion layer 26 is formed on the surface of the monocrystalline silicon substrate 11 below the floating gate 13 under such applied voltages. The inversion layer 26 is made up of electrons supplied from the drain diffusion layer 19 by a difference in potential between the drain voltage V_{D} and the control gate voltage V_{CG}. The electrons in the inversion layer 26 and those in the drain diffusion layer 19 are attracted to the control gate 15 to which the high voltage (V_{CG}) has been applied. Thereafter, these electrons pass through the gate insulative film 12 so as to be injected into the floating gate 13. The flow of the electrons in the gate insulative film 12 is called "Fowler/Nordheim tunnel current". An arrow in Figure 2 shows a direction of a movement of electrons. Therefore, a direction of the current flow is opposite to the direction of the arrow shown in Figure 2.

Thus, data is written into the sidewall type flash EEPROM cell by injecting the electrons into the floating gate 13.

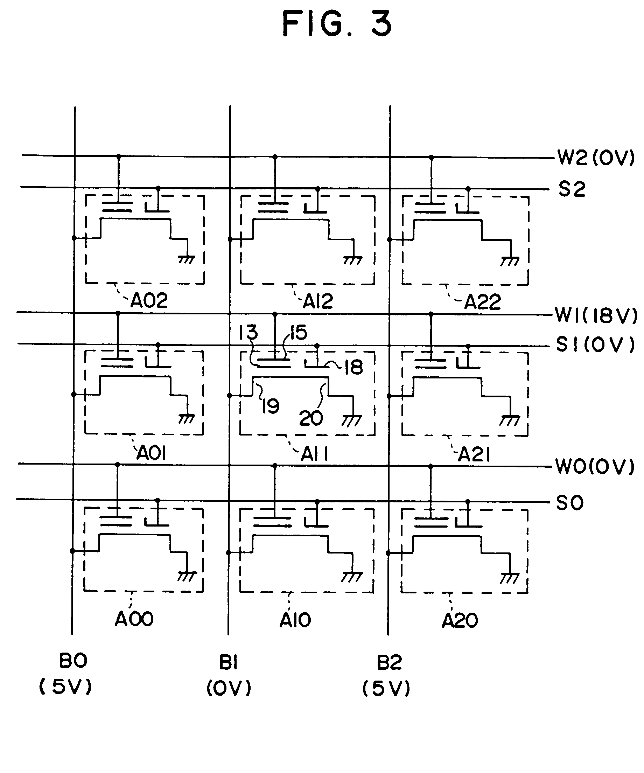

Further, the above operations will be described in connection with the case where the cell shown in Figure 2 is arranged in plural form. Figure 3 is a circuit diagram showing a memory device wherein the N type and sidewall type flash EEPROM cell shown in Figure 2 is arranged in plural form.

Respective cells AOO through A22 are arranged in the form of a matrix of 3x3. Elements of structure of the cell A11, which correspond to those shown in Figure 2, are identified by the same reference numerals. Similarly to the cell A11, elements of structure of other respective cells also correspond to those shown in Figure 2. However, there reference numerals are omitted. The drain diffusion layers 19 of the cells AOX (X = 1, 2, 3) are respectively electrically connected to one another by a bit line BO. The drain diffusion layers 19 of the cells A1X (X = 1, 2, 3) are respectively electrically connected to one another by a bit line B1. The drain diffusion layers 19 of the cells A2X (X = 1, 2, 3) are respectively electrically connected to one another by a bit line B2.

The control gates 15 of the cells AXO (X = 1, 2, 3) are respectively electrically connected to one another by a word line WO. The control gates 15 of the cells AX1 (X = 1, 2, 3) are respectively electrically connected to one another by a word line W1. Further, the control gates 15 of the cells AX2 (X = 1, 2, 3) are respectively electrically connected to one another by a word line W2.

The select gates 18 of the cell AXO (X = 1, 2, 3) are respectively electrically connected to one another by a select line SO. The select gates 18 of the cells AX1 (X = 1, 2, 3) are respectively electrically connected to one another by a select line S1. The select gates 18 of the cells AX2 (X = 1, 2, 3) are respectively electrically connected to one another by a select line S2.

The source diffusion layers 20 of the respective cells are grounded. Each of the source diffusion layers 20 may be set to a floating state.

A description will now be made of the case where data is written into the cell A11 of the cells AOO through A22 electrically connected to one another as described above.

Voltages of OV, 18V and OV are applied to or across the bit line B1 (selection bit line), the word line W1 (selection word line) and the select line S1 (selection select line) respectively. At this time, the Fowler/Nordheim tunnel current 23 flows in the gate insulative film 12 so as to store an electric charge in the floating gate 13.

At this time, the bit lines BO, B2 (non selection bit lines), the word lines WO, W2 (non selection word lines) and the select lines SO, S2 (non selection select lines) should be respectively supplied with voltages which do not cause variations in the quantity of electric charges already stored in the respective floating gates of the memory cells (AOO, AO1, AO2, A10, A12, A20, A21 and A22) other than the cell A11. The application of the voltages to their corresponding lines will be described below.

The memory cells A10 and A12 are first electrically connected to the selection bit line B1 (OV). Thus, a voltage of OV, for example, which does not cause the gate insulative films 12 of the memory cells A10 and A12 to conduct the Fowler/Nordheim tunnel current 23, is applied to each of the non selection word lines WO and W2 electrically connected to these memory cells A10 and A12.

Next, the memory cells AO1 and A21 are electrically connected to the selection word line W1(18V). Thus, a voltage, which does not cause the gate insulative films 12 of the memory cells AO1 and A21 to conduct the Fowler/Nordheim tunnel current 23, is applied to each of the non selection bit lines Bo and B2 electrically connected to these memory cells AO1 and A21. When a voltage of 5V, for example, is applied to each of the non selection bit lines BO and B2, the Fowler/Nordheim tunnel current 23 does not flow into the gate insulative films 12 of the memory cells AO1 and AO2 even if the voltage applied across the selection word line W1 is 18V.

Thus, when the voltage of OV is applied across each of the non selection word lines WO and W2 and the voltage of 5V is applied across each of the non selection bit lines BO and B2, the quantity of the electric charges stored in the floating gates 13 of the memory cells AOO, AO2, A20 and A22 respectively electrically connected to the non selection word lines and the non selection bit lines does not vary.

The role of the selection select line S1 is to prevent the inversion layer 26 and the source diffusion layer 20 from electrically conducting, the manner of which has been described with reference to Figure 2. If the voltage applied to the selection select line S1, i.e. the select gate voltage V_{SEL} shown in Figure 2 is of such a voltage that the inversion layer can be formed on the surface of the monocrystalline silicon substrate 11 below the select gate 18, the source diffusion layer 20 and the drain diffusion layer 19 are brought into a conducting state. Since the source diffusion layer 20 is grounded in this case, the surface of the monocrystalline silicon substrate 11 is brought to OV. Since the selection word line W1 is maintained at a high potential of 18V, the electrons flowing between the source diffusion layer and the drain diffusion layer are injected into the floating gate. The movement of the electrons to the floating gate occurs in each of the non selected memory cells AO1 and A21 to thereby produce miswriting.

In order to avoid such miswriting, the selection select line S1 is supplied with such a voltage that the inversion layer 26 is electrically disconnected from the source diffusion layer 20. When the select voltage V_{SEL} is OV as shown in Figure 2, for example, the inversion layer 26 is not formed on the surface of the monocrystalline silicon substrate 11 below the select gate 18. As a result, the source diffusion layer and the drain diffusion layer in each of the non selected memory cells AO1 and A21 are kept in non conduction. Therefore, the miswriting is no longer produced.

It is thus necessary to take into consideration the voltage applied to the select gate 18 or the width of the select gate 18 so that conducting current does not flow between the source and drain thereof.

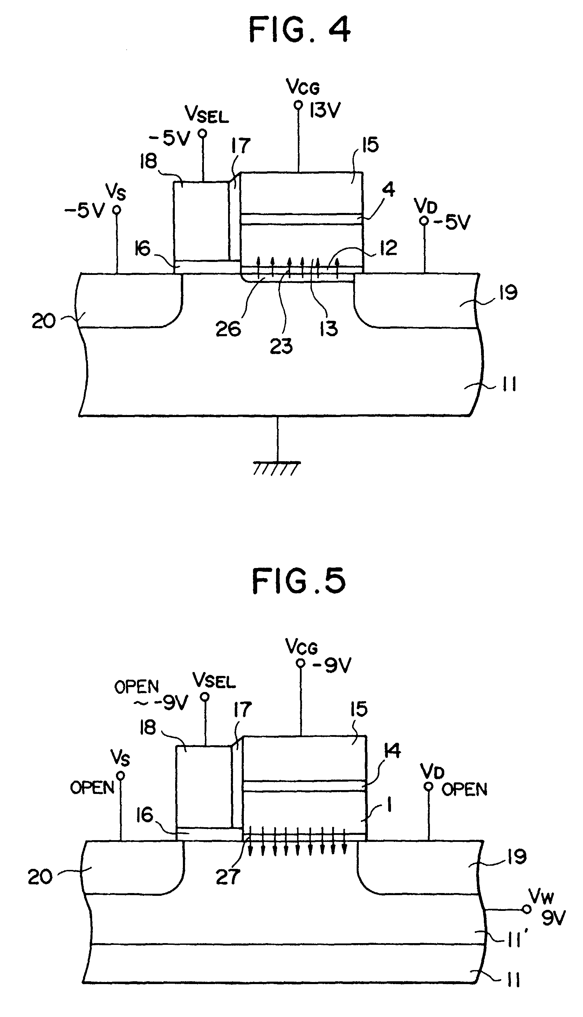

Figure 4 is a view for describing a second method of writing data into a sidewall type flash EEPROM cell. Figure 4 illustrates a well-layer as the silicon substrate 11.

The sidewall type flash EEPROM cell shown in Figure 4 is identical in structure to that illustrated in Figure 1. The same elements of structure as those shown in Figure 1 are identified by the same reference numerals. N-type impurities are implanted into a source diffusion layer and a drain diffusion layer.

The second data writing method will first be described. A drain voltage V_{D}, a control gate voltage V_{CG}, a select gate voltage V_{SEL}, a source voltage V_{S} and a well- layer voltage are set to -5V, 13V, -5V, -5V and -5V respectively. However, it is difficult that the substrate voltage keep to -5V. Therefore, a well-layer voltage Vw applied to the well layer formed within the substrate is set to -5V.

In a manner similar to the first data writing method which has been with reference to Figure 2, an inversion layer 26 is formed on the surface of a monocrystalline silicon substrate 11 provided below a floating gate 13 even under the applied voltages referred to above. The inversion layer 26 is made up of electrons supplied from a drain diffusion layer 19 by a difference in potential between the drain voltage V_{D} and the control gate voltage V_{CG}. The drain diffusion layer 19 is attracted to a control gate 15 to which the high voltage (V_{CG}) has been applied. Thereafter, these electrons pass through a gate insulative film 12 so as to be injected into the floating gate 13.

Thus, data is written into the sidewall type flash EEPROM cell by injecting the electrons into the floating gate 13.

Further, the quantity of electric charges stored in the floating gate of each non selected memory cell does not vary due to the setting of the non selection word and bit lines to -5V and OV.

A description will now be made of the case where the sidewall type flash EEPROM cell can be activated under an applied voltage of 3V.

In the data writing method described above when each of the gate insulative layers 12 shown in Figures 2 and 4 ranges in thickness from 60Å to 100Å, the difference in potential between the control gate 15 and the drain diffusion layer 19 requires a voltage range of about 12V to 20V to produce the Fowler/ /Nordheim tunnel current 23. This potential difference is large as compared with the case where data is written under the action of the conventionally-used hot electrons. However, when it is desired to write data using the Fowler/Nordheim tunnel current, the required amount of current is much less because of several pAmps per cell. Thus, even if an external power source is of 3V, the required current can be produced by an internal booster circuit. Since data represented in the form of 10kbits or so can be written at one time if the internal boosting capability of the internal booster circuit is rated to 10µA, the data can be written at a high speed.

A description will next be made of a method of erasing data. Figure 5 is a view for describing a method of erasing data from a sidewall type flash EEPROM cell, according to an embodiment of the present invention.

The sidewall type flash EEPROM cell illustrated in Figure 5 is substantially identical in structure to that shown in Figure 1. However, reference numeral 11' indicates a P-type well layer formed within a monocrystalline silicon substrate 11. Components of the sidewall type flash EEPROM cell shown in Figure 5, which correspond to those of the sidewall type flash EEPROM shown in Figure 1, are identified by like reference numerals. N-type impurities are implanted into a source diffusion layer and a drain diffusion layer.

A drain voltage V_{D}, a select gate voltage V_{SEL} and a source voltage V_{S} are respectively set to an open state. Further, a control gate voltage V_{CG} and a well-layer voltage V_{W} applied to the well layer 11' formed within the monocrystalline substrate 11 are set to -9V and 9V respectively.

In this condition, Fowler/Nordheim tunnel current 27 flows from the substrate to the floating gate through a gate insulative film 12. Therefore, the electrons stored in the floating gate 13 move into the surface of the monocrystalline silicon substrate 11 through the gate insulative film 12. This function is called to "erasing date".

According to the data erasing method of the present invention as described above, the electric charge stored in the floating gate 13 can be transferred over the entire surface of the mono-crystalline silicon substrate 11. As a result, a large current does not flow locally and the gate insulative film can be prevented from deterioration. Further, the number of times in which data is rewritten or reloaded can also be increased.

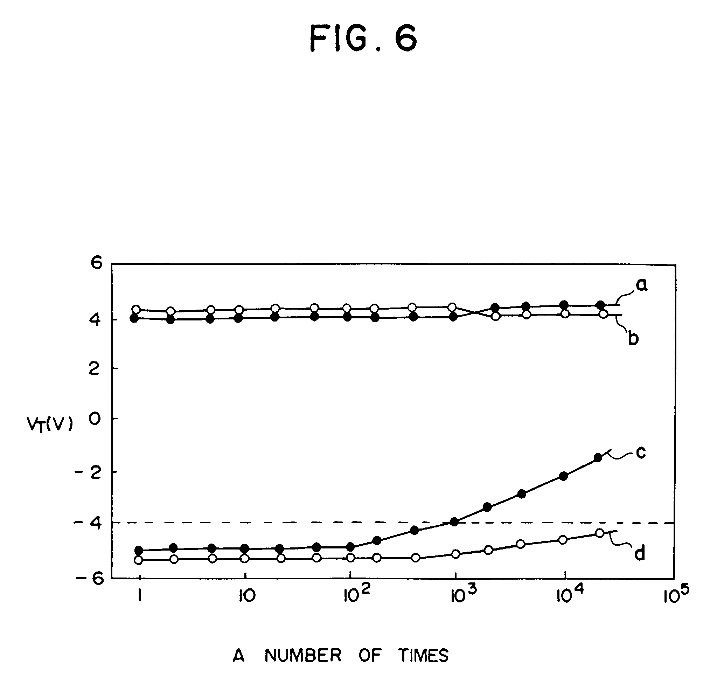

Figure 6 is a graph for describing the relationship between the number of times in which data is repeatedly written and erased and a threshold voltage (V_{T}) at the time that data is written under the action of the conventional hot electrons and data is written into the sidewall type flash EEPROM cell employed in the method described above. Here, the threshold voltage (V_{T}) represents a voltage at the time that current begins to flow between the source diffusion layer and the drain diffusion layer when the voltage applied to the control gate is varied. Further, a represents the result of the number of times vs threshold voltage, which has been obtained in conventional data writing, b shows the result of the number of times vs threshold voltage, which has been obtained in data writing by the first above-described method, c represents the result of the number of times vs threshold voltage, which has been obtained in conventional data erasing, and d shows the result of the number of times vs threshold voltage, which has been obtained in data erasing according to the present invention. Thus, when the number of times in which the data is written and erased in accordance with the conventional method, is about 10³, the threshold voltage is brought to -4V or higher after the erasion of the data. Even when, on the other hand, the number of times in which data is written using the first above-described method, is 10⁴ or more, the threshold voltage is brought to -4V or lower after the erasion of the data. As a result, the number of times in which the data is reloadable can be improved. Incidentally, the erasion of the data was made in accordance with a drain-tunnel erasing method.

## Claims

1. A method of erasing data from a semiconductor nonvolatile memory device having a drain (19) and a source (20) diffusion region of a first conductivity type in a semiconductor well region (11') of a second conductivity type, a control gate (15) over a floating gate (1) disposed over the whole of a first channel region, and a select gate (18) disposed over a second channel region, the first channel region adjoining the drain diffusion region (19) and extending therefrom, the second channel region extending between the source diffusion region (20) and the first channel region and adjoining these regions, said method comprising the steps of:
applying a first voltage (V_{CG}) to the control gate; and
simultaneously applying to the semiconductor well region (11') a second voltage (V_{W}) which is higher than the first voltage so that an electric charge stored in the floating gate is transferred to the semiconductor well region by a Nordheim-Fowler tunnelling current into the semiconductor well region.

2. A method according to claim 1, wherein the first voltage and the second voltage have an opposite polarity to each other.

3. A method according to claim 2, wherein the voltage difference between the first and second voltages is 10V or higher.

## Patentansprüche

1. Verfahren zum Löschen von Daten in einem nichtflüchtigen Halbleiterspeicher mit einem Drain- (19) und einem Source-Diffusionsbereich (20) von einem ersten Leitfähigkeitstyp in einem Halbleiter-Wannenbereich (11') von einem zweiten Leitfähigkeitstyp, einem Steuer-Gate (15) über einem schwebenden Gate (1), das über einem ganzen ersten Kanalbereich angeordnet ist, und einem Auswahl-Gate (18), das über einem zweiten Kanalbereich angeordnet ist, wobei der erste Kanalbereich an den Drain-Diffusionsbereich (19) angrenzt und sich von daher erstreckt und wobei sich der zweite Kanalbereich zwischen dem Source-Diffusionsbereich (20) und dem ersten Kanalbereich erstreckt und an diese Bereiche angrenzt, mit den Verfahrensschritten,
eine erste Spannung (V_{CG}) an das Steuer-Gate anzulegen, und
gleichzeitig eine zweite Spannung (V_{W}), die höher als die erste Spannung ist, an den Halbleiter-Wannenbereich (11') anzulegen, so daß eine im schwebenden Gate gespeicherte elektrische Ladung durch einen Nordheim-Fowler-Tunnelstrom in den Halbleiter-Wannenbereich hinein auf den Halbleiter-Wannenbereich übertragen wird.

2. Verfahren nach Anspruch 1, bei dem die erste Spannung und die zweite Spannung einander entgegengesetzte Polarität haben.

3. Verfahren nach Anspruch 2, bei dem die Spannungsdifferenz zwischen der ersten und der zweiten Spannung 10V oder höher ist.

## Revendications

1. Procédé pour effacer des données d'un dispositif de mémoire rémanente à semiconducteurs comportant une région de diffusion de drain (19) et une région de diffusion de source (20) d'un premier type de conductivité dans une région de puits de semiconducteurs (11') d'un deuxième type de conductivité, une grille de commande (15) sur une grille flottante (1) disposée sur la totalité d'une première région de canal, et une grille de sélection (18) disposée sur une deuxième région de canal, la première région de canal rejoignant la région de diffusion de drain (19) et s'étendant à partir de celle-ci, la deuxième région de canal s'étendant entre la région de diffusion de source (20) et la première région de canal et réunissant ces régions, ledit procédé comprenant les étapes suivantes :
l'application d'une première tension (V_{CG}) à la grille de commande ; et
l'application simultanée à la région de puits de semiconducteurs (11') d'une deuxième tension (V_{W}) qui est supérieure à la première tension, de telle sorte qu'une charge électrique stockée dans la grille flottante soit transférée à la région de puits de semiconducteurs par un courant d'effet tunnel de Nordheim-Fowler dans la région de puits de semiconducteurs.

2. Procédé selon la revendication 1, dans lequel la première tension et la deuxième tension ont une polarité opposée l'une à l'autre.

3. Procédé selon la revendication 2, dans lequel la différence de tension entre les première et deuxième tensions est de 10 V ou plus.
